# EUROPEAN PATENT APPLICATION

(11) **EP 4 679 484 A1**
(43) Date of publication of application: **14.01.2026**
(21) Application number: 25188453.2
(22) Date of filing: 09.07.2025
(51) Int. Cl.: H01J 37/22, H01J 37/26, H01J 37/28

(54) **CHOOSING TIME-RELATED AND QUALITY-RELATED CHARGED PARTICLE BEAM SCANNING PARAMETERS**

(30) Priority: 11.07.2024 US 202463669797 P; 03.04.2025 US 202563783085 P
(71) Applicant: FEI Company, Hillsboro, OR 97124 (US)
(72) Inventor: VÍTECEK, Jirí, Boleradice (CZ); KISA, Daniel, Brno (CZ); JANCÍK, Radek, Brno (CZ); KUCERA, Adam, Brno (CZ); PETRUS, Bruno, Bratislavsky kraj (SK)
(74) Representative: Boult Wade Tennant LLP

(57) **Abstract**

A method for constructing an operational-settings prediction model, comprises: (I) setting one or more microscope operational parameters to respective initial values; (II) directing a charged particle beam onto a location of a specimen of a known sample class and imaging or analyzing the location using the most recently set microscope operational parameters while detecting emissions from the specimen; (III) repeatedly: (i) changing a value of at least one of the one or more operational parameters; (ii) directing the charged particle beam onto the location and imaging or analyzing the location using the most recently set microscope operational parameters while detecting emissions from the location; and (iii) recording the values of the microscope operational parameters and recording a value that is a measure of the detected emissions from the location; and (IV) constructing and storing a mathematical relationship, pertaining to the known sample class, between at least one variable that represents a microscope operational parameter and a variable that represents the detected emissions.

## Description

### TECHNICAL FIELD

The present application relates, in general, to charged particle beam microscopes and charged particle beam microscopy and, more particularly, to optimization of analytical instrument settings for Focused Ion Beam (FIB) microscopy and systems therefor, Transmission Electron Microscopy (TEM) and systems therefor, Scanning Electron Microscopy (SEM) and systems therefor, Scanning Transmission Electron Microscopy (STEM) and systems therefor as well as dual-beam systems that include both a focused ion beam apparatus and an electron microscope and tri-beam systems that include a focused ion beam apparatus, an electron microscope and a laser.

### BACKGROUND

Material studies that involve characterizing the properties (e.g., molecular or atomic structure, topography and chemical composition) of probes in the micro-and nanoscopic regime can be performed through the implementation of Charged Particle Beam (CPB) microscope systems. Electron microscope systems can perform imaging analysis as well as a variety of spectrochemical compositional analyses and structural analyses. These techniques are made possible by directing a beam of electrons onto a sample. Similar types of imaging and analyses may be conducted using Focused Ion Beam (FIB) systems, in which the incident charged-particle beam (CPB) consists of ions instead of electrons. However, FIB systems produce images at lower resolution than what is attainable using SEM systems.

For example, a Scanning Electron Microscope (SEM) may be configured to scan the surface of the sample with a primary charged-particle beam (e.g., an electron beam) and acquire an image of the sample based on various types of emissions e.g., emissions of backscattered, transmitted or secondary electrons. These emissions result from the interaction of the electron beam with the particles of the sample (such as atoms). Backscattered electrons (BSE) originate from the primary electron beam, which, as the name suggests, are scattered back (e.g., out of the sample) via elastic scattering upon interaction with the sample atoms. The number of backscattered electrons at each scan location on the sample depends on the atomic number of the chemical elements (e.g., elements within metal samples, minerals, alloys, organics, etc.) located in the corresponding scan location. Thus, the brightness variations (e.g., gray-level variations) within a BSE image are generally indicative of the composition variations within the sample. Alternatively, a Transmission Electron Microscope (TEM) may be configured to record electrons that are transmitted through a sample.

Generally, each area of a sample that is undergoing electron microscopic imaging or analysis must be exposed to an electron beam for a time period (i.e., a pixel "dwell time") during which emissions from that area of the sample are detected and recorded. Conventionally-operated SEMs (as well as other modalities such as conventional TEMs) may use fixed dwell times per area on a sample. Under conditions in which particular settings of microscope operating parameters are employed, the dwell time must be sufficiently long such that a usable signal, having a magnitude above background noise, is recorded. Unfortunately, some choices of SEM or TEM instrument operating parameters, when employed for the imaging or analysis of certain samples (e.g., proteins, viruses, circuits, transistors, etc.) may require electron beam exposure for periods of time which may damage the samples. Certain types of samples (e.g., biological samples) are particularly sensitive to beam damage from electron beams as the electrons can cause thermal expansions, structural damage, or other sample degradation. Thus, with some electron microscope operating parameter settings, an incorrect choice of dwell time or apparatus operating parameters may result in extended scan periods wherein the extended period of time between the attainment of a desired signal magnitude and the end of the fixed dwell time is unnecessary and, as a result, the sample is unnecessarily damaged.

Other parameters that may affect the total exposure of a sample to an electron beam include the user's choice of line integration imaging mode versus frame integration imaging mode and the total number of exposures (in either line integration or frame integration mode) that are required for an acceptable analysis. Line integration comprises co-adding collected signal data from each scan line that is repeatedly scanned multiple times and displaying the so co-added data from each line as an actual image line. Frame integration comprises co-adding of data from a specified number of repeated image frames acquired from a single area on a sample.

Some CPB workflow procedures that pertain to three-dimensional tomographic reconstructions of micron-size and sub-micron-size may require the acquisition of thousands of CPB microscope images. In one such workflow procedure, known as the slice-and-view workflow, a single sample may be imaged multiple times, each image being acquired after destructive removal of a thin layer of material (of micron-size or sub-micron-size thickness) from a previous surface of the sample. In a variation of the workflow, each layer may be removed by an ultra-microtome apparatus and thereby preserved as a separate respective lamella, with all such lamellae being deposited onto one or more substrates for subsequent imaging. With such timeintensive workflows, it is desirable to obtain as much high-quality data as possible in the shortest possible time. Especially with cryo-imaging use cases, in which delicate internal structures of lamellae or other samples are preserved by flash freezing at cryogenic temperatures, analysis time is critical and every additional minute of handling or extended analysis creates an additional risk of sample deterioration. It is undesirable to use an unnecessarily high dwell time or an unnecessarily large number of summed scans, in line and/or frame integration, as either of these can lead to an unnecessary extension of the entire job or excessive irradiation and destruction of the sample. Conversely, with a dwell time that is too short, line and/or frame integration can lead to situations in which the resulting data will lack sufficient quality and, as a result, the analytical results will not be useable. In the latter instance, valuable microscope time and the sample are lost.

For an inexperienced user, due to the number of input instrument operational parameters that may need to be set or adjusted (e.g., class and/or physical configuration of the sample, acceleration voltage, beam current, lens mode, detector type, detector mode, number of integrations, etc.), it is very difficult to determine which dwell time, integration mode and number of exposures will be beneficial for producing high-quality data while, at the same time, not unnecessary extending the total time required for analysis or damaging the sample(s). Even for more experienced users, it is difficult to determine the most suitable values of these parameters. Therefore, most users settle for using a commonly-used dwell time value (e.g. 3000 ns), or commonly-used number of exposures even though these chosen parameters may not be optimal for the sample at hand. For example, a suitable dwell time can vary according to the above input parameters from the lower hundreds of nanoseconds to the higher thousands of nanoseconds. Because of the size of this range, there are many opportunities for optimization and a need in the art for procedures for optimizing timeintensive charged-particle-beam imaging and analysis workflows.

### BRIEF SUMMARY

This disclosure describes methods and apparatus for automatically selecting Charged Particle Beam (CPB) microscope scanning parameters that yield a desired tradeoff between image quality metrics and the acquisition time and other scanning parameters. This can be done by modeling the impact of the scanning parameters upon the image quality. Examples of such parameters include: dwell time, the choice of line integration versus frame integration and total number of exposures. Other parameters that may be included in the optimization include: electron or ion beam energy, electron or ion beam current, lens current and/or lens voltage, detector(s) to be used, detector gain, sample damage threshold, acceptable image noise threshold, and minimum acceptable signal per scan. The image quality model or metric, as well as the selection algorithm, can be either explicitly formulated (e.g. standard deviation of the noise), or it can employ machine learning methods to capture more complex phenomena.

According to a first aspect of the present disclosure, a method for constructing a Charged Particle Beam microscope operational-settings prediction model, comprises:
setting one or more microscope operational parameters to respective initial values;
directing a charged particle beam onto a location of a specimen of a known sample class and imaging or analyzing the location using the most recently set microscope operational parameters while detecting emissions from the specimen;
repeatedly:
   changing a value of at least one of the one or more operational parameters;
   directing the charged particle beam onto the specimen location and imaging or analyzing the specimen location using the most recently set microscope operational parameters while detecting emissions from the specimen location; and
   recording the values of the microscope operational parameters and recording a value that is a measure of the detected emissions from the specimen location; and
constructing and storing a mathematical relationship, corresponding to a best-fit model, that pertains to the known sample class, between at least one variable that represents a microscope operational parameter and a variable that represents the detected emissions.

According to a second aspect of the present disclosure, a method for imaging or analyzing a specimen of a known sample class within a charged particle beam (CPB) microscope is provided, the method comprising:
(a) receiving an identification of the sample class from a user;
(b) setting values of one or more CPB microscope operational parameters to use for imaging or analysis of the specimen of the sample class based on a CPB microscope operational-settings prediction model that pertains to the sample class, wherein the operational-settings prediction model is constructed by a method as recited above;
(c) directing a charged particle beam onto the specimen of the known sample class and imaging or analyzing the specimen using the values, as set in step (b), of one or more CPB microscope operational parameters.

Further aspects of the invention are set out in the following numbered clauses:
1. A method for imaging or analyzing a specimen of a known sample class within a charged particle beam (CPB) microscope, comprising:
   (a) receiving an identification of the sample class from a user;
   (b) setting values of one or more CPB microscope operational parameters to use for imaging or analysis of the specimen of the sample class based on a CPB microscope operational-settings prediction model that pertains to the sample class, wherein the operational-settings prediction model is constructed by a method as recited in claim 1;
   (c) directing a charged particle beam onto the specimen of the known sample class and imaging or analyzing the specimen using the values, as set in step (b), of one or more CPB microscope operational parameters.
2. A method as recited in clause 1, wherein one of the values that is set in step (b) comprises a value of a minimum dwell time that is predicted to yield images having an acceptable noise level, upon imaging specimens of the known sample class with the CPB microscope.
3. A method as recited in clause 1, wherein one of the values that is set in step (b) comprises a value that distinguishes between imaging in frame integration mode and imaging in line integration mode.
4. A method as recited in clause 1, wherein one of the values that is set in step (b) comprises a value that indicates how many frames are to be summed together during operation in frame integration mode or how many lines are to be summed together during operation in line integration mode.
5. A method as recited in any of the previous clauses, wherein the charged particle beam is an electron beam within an electron microscope.
6. A method as recited in any of clauses 1-4, wherein the charged particle beam is an ion beam within a Focused Ion Beam apparatus.
7. A method for performing charged-particle-beam (CPB) investigation of a sample using a CPB microscope, the method comprising:
   retrieving information from an operational-settings prediction model that relates instrumental and other operational settings of the CPB microscope to predicted quality of data generated during CPB investigation of the sample;
   based on the retrieved information, choosing instrumental operational settings to be used during the CPB investigation of the sample; and
   performing a plurality of analyses of the sample, comprising repeatedly:
      selecting a new area on the sample for analysis;
      performing an analysis of the sample area using the chosen instrumental operation settings; and
      assessing whether the quality of data generated during a most-recent analysis is at or above a threshold;
   whereby, if the assessed quality of the data from one or more most-recent analyses is below the threshold, either choosing new operational settings, based on the model or, otherwise, updating the model.
8. A method as recited in clause 7, wherein the retrieving of information from the operational-settings prediction model comprises generating the model prior to commencing the plurality of analyses.
9. A method as recited in clause 8, wherein the composition of the sample surface is unknown prior to commencing the investigation.
10. A method as recited in clause 8, wherein, after the performing of an analysis of a sample area, assessing if the sample area has been damaged by a most-recent analysis, wherein, if it is assessed that the sample area has sustained damage during the most recent analysis, either new operational settings are chosen, based on the model or, otherwise, the model is updated.

### BRIEF DESCRIPTION OF THE DRAWINGS

FIG. 1 is a schematic depiction of various components of a Scanning Electron Microscope (SEM) system illustrating conventional components, in solid lines, as well as to additional components and connections, in dashed lines, that are relevant to the present teachings;
FIG. 2 is a flow diagram of a method, in accordance with the present teachings, for constructing a prediction model of charged particle microscope quality metrics as a function of various scanning parameter settings that affect one or both of total analysis time and image quality, wherein the mathematical model is updated in real-time while performing a program of multiple sample analyses;
FIG. 3 is a graphical example of construction of a mathematical relationship between image noise, as plotted against pixel dwell time, in milliseconds;
FIGS. 4A-4J are electron microscope images from which the image noise values of FIG. 3 are calculated;
FIG. 5A is a flow diagram of a method, in accordance with the present teachings, for utilizing a previously-determined prediction model of charged particle microscope quality metrics during investigation of any sample, regardless of whether or not the identity of the sample is known; and
FIG. 5B is a flow diagram of a method, in accordance with the present teachings, for either utilizing a prediction model of charged particle microscope quality metrics or, alternatively, initializing or updating the model while concurrently analyzing a sample using a CPB microscope.

### DETAILED DESCRIPTION

As used in this application and in the claims, the singular forms "a", "an", and "the" include the plural forms unless the context clearly dictates otherwise. Additionally, the term "includes" means "comprises". Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

In some examples, values, procedures, or apparatuses are referred to as "lowest", "best", "minimum", "greater", "less than", "equal to" or the like. It will be appreciated that such descriptions are intended to indicate that a selection among many used functional alternatives can be made, and such selections need not be better, smaller, or otherwise preferable to other selections.

The term "image" is intended to comprise a two-dimensional array of data. Each element of the array is characterized by its coordinates and by one or more numerical values (e.g., a simple gray-scale value; a color specified as separate intensity values for red, blue and green; separate values for hue, saturation and lightness, etc.). Thus, the image may refer to a visual representation of the sample in gray level variations and/or color variations and/or intensity variations. The array elements may, for example, be pixels or comprise a plurality of pixels. Further, each portion of the image or element of the area may correspond to a specific respective area or point on the sample.

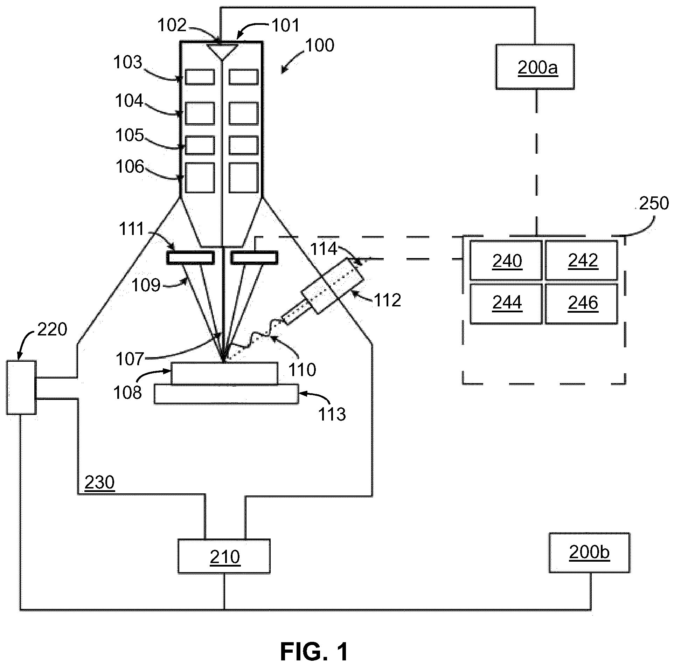

FIG. 1 shows, in schematic fashion, various components of a Scanning Electron Microscope (SEM) system **100.** Although an SEM system is specifically depicted in FIG. 1, the general principles described herein may also be applied to a Scanning Transmission Electron Microscope (STEM) system as well as to a Focused Ion Beam (FIB) system. The components that are outlined by or connected by solid lines are conventional components, as are currently known in the art. The optional components that are outlined by or connected by dashed lines are relevant to the present disclosure. The scanning microscope system **100** may be configured for generating a primary beam of charged particles (e.g., electrons or ions). In this example, the primary beam comprises an electron beam **107.** An electron source **102** may be configured for emitting the electron beam, wherein a voltage is applied between the electron source **102** and an anode **103.** The applied voltage may preferably range from at least hundreds of volts to at most 30 kV. The scanning microscope system may also comprise electromagnetic lenses that may be configured for controlling the path of the electron beam. The electromagnetic lenses may comprise at least one condensing lens **104.** The condensing lens **104** may be configured for determining the size of the electron beam. Moreover, the electromagnetic lenses may comprise at least one objective lens **106.** The objective lens **106** may be configured for focusing the electron beam to a scan point on the sample. The scan point may correspond to an electron-beam spot on a sample **108.** The dimensions and the shape of the scan point may depend on the focusing properties of the electromagnetic lenses (e.g. applied current) and the working distance between the scanning electron microscope **101** and the sample **108.** A scanning coil **105,** which may be either magnetic or electrostatic, may be configured for deflecting the electron beam **107** over a plurality of scan locations in one or two dimensions. This scanning capability may enable two-dimensional scanning of the sample **108.** Each scan point may correspond to a respective pixel of an image of the sample generated by the electron microscope **101.**

The scanning microscope system **100** can be configured to detect at least first emissions **109** and, optionally, second emissions **110** from each scan point of the sample **108** upon interaction of the electron beam **107** with the respective scan point. The first emissions **109** may comprise emissions of charged particles, such as backscattered electrons. However, the first emissions may also comprise emissions of secondary, transmitted and/or Auger electrons. Further, the second emissions **110** may comprise emissions of photons, such as X-rays and/or light (e.g., visible light).

The SEM system **100** may also comprise a first detector **111,** wherein the first detector **111** is configured for detecting the first emissions **109** from a series of scan points that are exposed to the electron beam **107** in a sequential manner. In particular, the first detector **111** may be configured for detecting the first emissions over a first dwell time at each scan point. In some examples, the first detector **111** may comprise a backscattered electron detector, such as a segmented silicon drift detector. However, the backscattered electron detector may also comprise other types of solid-state detectors. Moreover, the first detector **111** may also comprise a secondary electron detector, such as an Everhart-Thornley detector.

Further, the SEM system may comprise an optional second detector **112,** wherein the second detector **112** may be configured for detecting the second emissions **110** from the various scan points in a sequential manner. In particular, the second detector **112,** may be configured for detecting the second emissions over a second dwell time at each second scan point. For example, the optional second detector **112** may comprise an X-ray detector, wherein the X-ray detector may comprise a silicon drift detector. However, the X-ray detector may also comprise other types of detectors (e.g., scintillation detectors). The second detector **112** may be tilted with respect to the surface of the sample **108.** The angle between a center line **114** of the second detector and the sample surface may be adjustable and may range from 0° to at most 90°. The X-ray detector may comprise an energy-dispersive spectrometer (EDS). The energy bandwidth of the EDS may range from 0 keV to over 20 keV. In another modality, the X-ray detector may comprise a wavelength-dispersive spectrometer (WDS). Further, the second detector **112** may also comprise, or may alternatively comprise an electron energy loss spectrometer (EELS), an electron backscatter diffraction (EBSD) detector, a photodetector or a cathodoluminescence spectrometer.

If the system **100** is an STEM system (instead of the illustrated SEM system), at least one of the depicted detectors **110, 112** may be omitted and replaced by a transmitted electron detector (e.g., a CMOS detector, not shown) that is disposed below the sample **108** in order to detect electrons that are transmitted through the sample. In such instances, the system **100** may also comprise substage objective lens and projection lens components (not shown) between the sample and the transmitted electron detector.

The scanning microscope system **100** may further comprise a control unit **200a.** The control unit **200a** may be configured for controlling the power supply and operation of the condensing lens **104,** the objective lens **106,** the scanning coil **105** and the movable stage **113.** Further, the scanning microscope system may comprise a vacuum system. The vacuum system may comprise a vacuum controller **200b,** a mechanical pumping system **210,** an ultra-high vacuum pump **220** (such as an ion pump) and a vacuum chamber **230.** The vacuum controller **200b** may be configured for controlling the operation of the mechanical pumping system **210** and the ultra-high vacuum pump **220.** The mechanical pumping system **210** and the ultra-high vacuum pump **220** may be configured for providing an ultra-high vacuum within the vacuum chamber **230.** The vacuum chamber may be configured for containing the sample **108,** the movable stage **113,** the first detector **111,** the second detector **112** or parts thereof, and the scanning electron microscope **101** or parts thereof.

The sample **108** may be positioned on top of a movable stage **113.** The movable stage **113** may be configured for performing one or more of: two horizontal movements, a vertical movement, a tilting movement, and/or a rotational movement, either within or with respect to the plane of the sample. The two horizontal movements may comprise selecting a field of view. The vertical movement may change a height of the sample and thus the depth of focus and/or the image resolution.

The system shown in FIG. 1 further comprises a data-processing system **250.** The data-processing system **250** may comprise one or more processing units configured to carry out computer instructions of a program (e.g. machine readable and executable instructions). The processing unit(s) may be singular or plural. For example, the data-processing system **250** may comprise at least one of CPU, GPU, DSP, APU, ASIC, ASIP or FPGA.

In one example, a spectrum processing component **244** of the data processing system **250** may be configured for generating X-ray spectra based on X-rays detected by an X-ray detector **112.** In particular, if the X-ray detector is used in Energy Dispersive Spectroscopy (EDS) modality, then the spectrum processing component **244** may be configured for counting and sorting the detected X-rays (at each respective scan point) based on the energies of the respective X-rays for the duration of the second dwell time. However, if the X-ray detector is used in Wavelength Dispersive Spectroscopy (WDS) modality, then the spectrum processing component **244** may be configured for counting and sorting detected X-rays based on the wavelengths of the respective X-rays during the second dwell time. The generated X-ray spectra may be used to characterize aspects of the sample or sample portion to which they pertain. In some cases, the spectra may be used to create one or more specialized images of the sample such as an image of the spatial distribution of a particular element within the sample.

In another example, an image processing component **246** of the data processing system **250** may be configured for constructing images of the sample where the images are based on data received from the first detector **111** and/or the optional second detector **112.** The data may comprise, for each scan point, a number of digital counts detected by a detector over the course of a time period having a predetermined time duration (i.e., first or second dwell time), wherein the number of counts received during the predetermined time duration is translated, by the processing unit **246** into a respective intensity of a respective image pixel. In some instances, the number of counts may pertain to the detection, by the second detector **112,** of X-rays having a certain energy (in EDS mode) or having a certain wavelength (in WDS mode). In some other instances, the number of counts may pertain to detection, by the first detector 111, of a quantity of electrons emitted from or scattered from the scan point. In some other instances, the number of counts may pertain to detection, by a substage detector (not shown), of a quantity of electrons transmitted through the sample. The processing component **246** may store the number of detected counts received from each scan point in a respective location of a digital array. The processing component **246** may further store scaling information that may be used to translate the digital array locations into physical coordinates of each respective scan point on the sample.

Further, the data-processing system **250** may comprise a parameter settings component **242.** The parameter settings component may accept, from user input, the values of apparatus parameters that are to be employed for subsequent electron microscopic imaging and/or analysis of a sample. Such parameters may include, but are not limited to: scanning mode, electron or ion beam energy, electron or ion beam current, lens current and/or lens voltage, detector(s) to be used, detector gain, dwell times, sample damage threshold, acceptable image noise threshold, minimum acceptable signal per point, etc. Preferably, however, most of such instrumental parameters are determined automatically by the parameter settings component **242,** using methods in accordance with present disclosure (e.g., see method **400,** described herein below), after receiving minimal information from a user (e.g., limited to one or more of sample class, desired image quality or signal level, acceptable sample damage threshold, desired maximum analysis time). The parameter settings adjustment component **242** may be further configured for implementing the settings during subsequent analysis.

The data-processing system **250** may further comprise memory components, such as a data-storage component **240.** The data-storage component **240** as well as the data-processing system **250** may comprise at least one of main memory (e.g. RAM), cache memory (e.g. SRAM) and/or secondary memory (e.g. HDD, SSD). The data-processing system **250** may comprise volatile and/or non-volatile memory such as SDRAM, DRAM, SRAM, Flash Memory, MRAM, F-RAM, or P-RAM. The data-processing system **250** may comprise internal communication interfaces (e.g. busses) configured to facilitate electronic data exchange between components of the data-processing system **250,** such as, the communication between the memory components and the processing components. The data-processing system **250** may include external communication interfaces configured to facilitate electronic data exchange between the data-processing system and devices or networks external to the data-processing system. In the example of FIG. 1, the external communication interfaces may be configured for facilitating an electronic connection between the processing components of the data-processing system **250** and components of the scanning microscope system **100,** such as the control unit **200a.**

Furthermore, the external communication interfaces may also be configured for establishing an electronic data exchange between the data-processing system **250** and the first detector **111.** The external communication interfaces may also be configured for facilitating an electronic connection between the data-processing system **250** and the second detector **112,** if present. For example, the detected backscattered electron data from every scan point may be stored in the data-storage component **240.** Likewise, a backscattered charged-particle-beam image of the sample and, optionally, X-ray spectra or other types of spectra from each scan point may be stored in the data-storage component **240.**

The data-processing system may also comprise network interface card(s) that may be configured to connect the data-processing system to a network, such as, to the Internet. The data-processing system may be configured to transfer electronic data using a standardized communication protocol. The data-processing system may be a centralized or distributed computing system. The data-processing system may comprise user interfaces, such as an output user interface and/or an input user interface. For example, the output user interface may comprise screens and/or monitors configured to display visual data (e.g. a backscattered charged-particle beam image of the sample or an X-ray spectrum). The input user interface (e.g. a keyboard) may be configured to allow the insertion of text and/or other keyboard commands (e.g. allowing the user to enter parameters for use during subsequent data acquisition) and/or a trackpad, mouse, touchscreen and/or joystick (e.g., configured for navigating a charged particle beam image or selecting regions of interest within such an image.

In some examples, the data-processing system **250** may be a processing unit configured to carry out instructions of a program. The data-processing system **250** may be a system-on-chip comprising processing units, memory components and busses. The data-processing system **250** may be a personal computer, a laptop, a pocket computer, a smartphone, a tablet computer. The data-processing system may comprise a server, a server system, a portion of a cloud computing system or a system emulating a server, such as a server system with an appropriate software for running a virtual machine. The data-processing system may be a processing unit or a system-on-chip that may be interfaced with a personal computer, a laptop, a pocket computer, a smartphone, a tablet computer and/or user interfaces (such as the upper-mentioned user interfaces).

At least one of the spectrum processing component **244,** the image processing component **246** and the parameter settings component **242** of the data-processing system **250** may be implemented in software. One, some, or all of these components may be a software component, or at least comprise one or more software components. The data-processing system **250** may be configured for running said software component(s), and/or for running a software comprising the software component(s). In other words, the components may comprise one or more computer instructions (e.g. machine-readable instructions) which may be executed by a computer (e.g. the data-processing system **250**). At least one of the spectrum processing component **244,** the image processing component **246** and the parameter settings component **242** may be stored on one or more different storage devices. For example, the at least one of the components may be stored on a plurality of storage components comprising persistent memory, for example a plurality of storage devices in a RAIDsystem, or different types of memory, such as persistent memory (e.g. HDD, SSD, flash memory) and main memory (e.g. RAM). The components may also be implemented at least partially in hardware. For example, at least one of the spectrum processing component **244,** the image processing component **246** and the parameter settings component **242** or at least a part of one of their functionalities may be implemented as a programmed and/or customized processing unit, hardware accelerator, or a system-on-chip that may be interfaced with the data-processing system **250,** a personal computer, a laptop, a pocket computer, a smartphone, a tablet computer and/or a server.

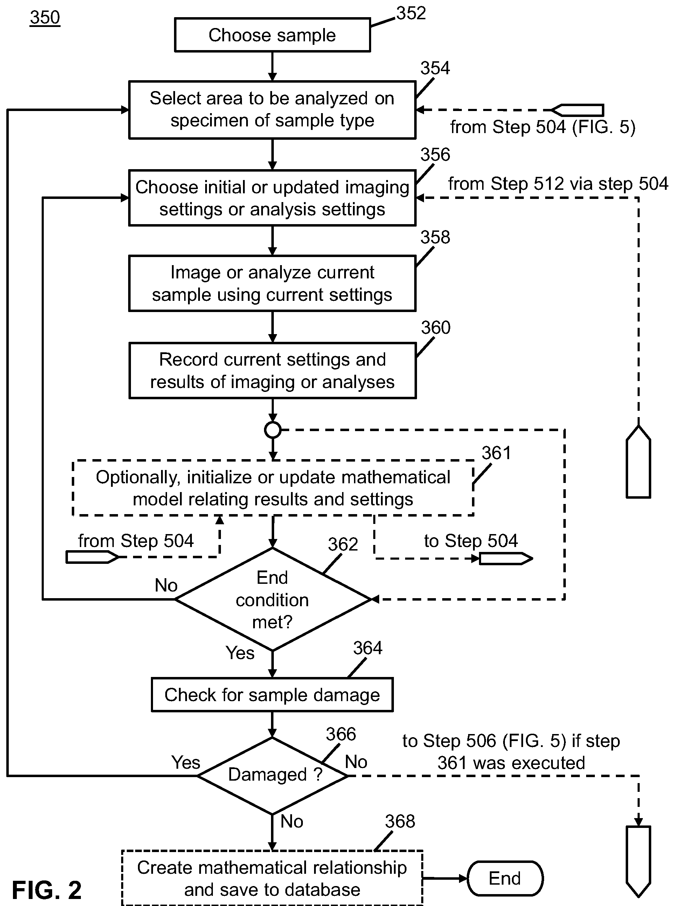

FIG. 2 is a flow diagram of a method, method **350,** in accordance with the present disclosure, for constructing a prediction model of charged particle microscope quality metrics (e.g., total time required, noise and/or signal level, level of sample damage) as a function of various scanning parameter settings (e.g., sample class, pixel dwell time, choice of line integration imaging mode versus frame integration imaging mode, etc.) that affect one or both of: total analysis time image quality and, sample preservation during analysis. The method **350** is useful as a preparatory procedure for choosing operational parameters for charged particle beam imaging or charged particle beam spectrometry of samples that that belong to a particular class of samples, where the properties (e.g., composition, surface configuration, thickness, etc.) of members of the class are not expected to significantly vary among samples belonging to the class. For example, a first class of samples could comprise polished metallic samples that are alloys within a particular compositional range. A second class of samples could comprise glasses of various related compositions. A third class of samples could include various semiconductors. In such instances, a single program of characterizing the effects changing CPB operations settings may be developed for each sample class. The determined useful settings may then be catalogued in a database entry that pertains to the sample class. During subsequent analysis of any member of the sample class, the cataloged operational settings for the class may be retrieved from the catalogued values. The database may comprise various such entries, each one pertaining to a different respective class of samples.

In a first step, step **352** of the method **350** (FIG. 2), a representative specimen of a selected class of samples is chosen. In step **354,** an area of the specimen is selected for analyses. Subsequent steps **356** through **361** of the method **350** comprise a group of steps that pertain to a series of charged-particle-beam (CPB) analyses of the selected sample area. Specifically, the execution of the method **350** iterates the steps **354** through **361,** where each iteration corresponds to a single analysis (e.g., an image of an area, a line scan, a spectral analysis, etc., each of which may comprise a plurality of co-added measurements), which is performed in step **358.** In step **356,** initial or new imaging settings or analysis settings are chosen. The settings are "initial" settings if step **356** is being executed for the first time after the selection of the area to be analyzed in the immediately preceding execution of step **354** and are "new" settings otherwise. Next, in step **358,** the specimen is imaged or analyzed using the imaging or analysis settings that were chosen during the most recent execution of step **356.** Step **358** may include multiple individual imaging or analysis measurements on the same specimen location. For example, the execution of step **358** may include acquisition of multiple image frames or line scans that are subsequently co-added. Similarly, the execution of step **358** may comprise an analysis that includes the acquisition of multiple X-ray spectra that are co-added.

After completion of each image acquisition(s) or analysis/analyses in step 358, the results are recorded in step **360.** This step may include recording the results of imaging and/or analyses as well as recording the current operational settings. In step **361,** a mathematical model that relates instrument settings to analytical results is either initialized or updated. The model is "initialized" if there is no existing predictive model that is known to be suitable for the chosen sample type and if the step **361** is being executed for a first time after the selection of the area to be analyzed in step **354.** Otherwise, the model may be "updated" in step **361** or, alternatively, the step **361** may be bypassed (see dashed arrow in FIG. 2). Initialization of the model may include setting initial trial operational and instrumental settings which are to be used during a first data collection if such have not been chosen prior to execution of the method. The initialization may also include choosing a particular mathematical form of the model which may include: the number of independent variables (i.e., operational and/or instrumental settings); mathematical form(s) of fitted curves, the number of adjustable parameters, etc. During subsequent iterations of the loop of steps **356-361,** the chosen model may be "updated" in step **361.** The updating may include calculating new best-fit curves that that incorporate most-recently collected data (i.e., during the most recent execution of step **360**) and potentially modifying previously-chosen or previouslycalculated model parameters in accordance with the new best fits. The updating may further include identifying outlier results and excluding such outliers from the fitting procedure. The updating of the mathematical model may be bypassed if, for example, a statistical analysis (e.g., a goodness-of-fit analysis) indicates that the model adequately represents observed results.

Step **362** is a decision step in which the course of execution of the method depends on whether or not a pre-defined ending condition for terminating the repetitions of the steps **356-360** has been met. There may be multiple such ending conditions, any one of which, if met, may cause the termination of the repeated analyses. For example, the repeated analyses may be terminated upon the achieving of a certain predetermined maximum number of analyses or, alternatively, an elapse of an allotted maximum amount of time for completing the analyses. As another example, the series of analyses may be terminated if an observed signal-to-noise ratio in a set of recently-acquired analyses is above a predetermined threshold level. As yet another example, the set of analyses may be terminated if the statistical fit of the model to the observed data is sufficiently good that the model may be used to predict beneficial instrumental settings through either interpolation or extrapolation. If, at step **361,** none of the pre-defined ending conditions have been met, then execution returns, via the "No" branch of step **362,** to step **356** at which at least one operational setting is changed to a new value. For example, if a particular operational parameter specifies the number of image frames or line scans are co-added in the data acquisition step **358,** then this parameter may be increased for the next execution of step **358.**

If, at the execution of the decision step **362,** it is determined that an ending condition has been met, then execution of the method **350** proceeds to step **364,** at which it is determined if the most recent set of analyses have caused damage of the sample at the selected sampled area. The assessment of whether sample damage has occurred may be made by imaging the sample at a lower magnification and observing image contrast between the selected sampled point/area and the surrounding area of the sample. Such image contrast may be indicative of sample damage, since the sampled point/area was initially chosen, prior to analysis, as being representative of the general sample. It should be noted that the damage-check step **364** and the subsequent decision step **366** may optionally occur earlier in the sequence of executed steps such as, for instance, after step **358** and prior to step **360.** If sample damage is observed, then execution of the method **350** branches to step **354** (e.g., via the "Yes" branch of step **366**) at which one or more of the prior parameter settings are modified. Execution of the method then returns to step **356** at which a new analysis point/area on the sample is chosen. The new analysis location may be necessary because the observed damage to the previous sample location may cause subsequent analyses on the damaged location to be unreliable.

Once execution of the method **350** has passed along both the "Yes" branch of step **362** and the "No" branch of decision step **366** (the solid-line arrow below step **366**), the execution passes to step **368.** At step **368,** the model is finalized and beneficial operational settings or ranges of operational settings for carrying out beneficial CPB measurements are recorded, such as by an entry in a database, where the entry pertains to analyses of samples of the class of the selected class of samples. Preferably, the form and values of parameters of the model are also recorded. This step may also include recording the results of imaging and/or analyses during the execution of the method. The operational settings, or ranges of settings, that are recorded in the entry (or that may be determined from the recorded model parameters) may then be employed for all subsequent CPB analyses of specimens that qualify as members of the selected sample class. The database may contain a plurality of other, similar entries, where each entry corresponds to CPB operational settings that are to be employed during CPB imaging or spectroscopy of a member of the sample class.

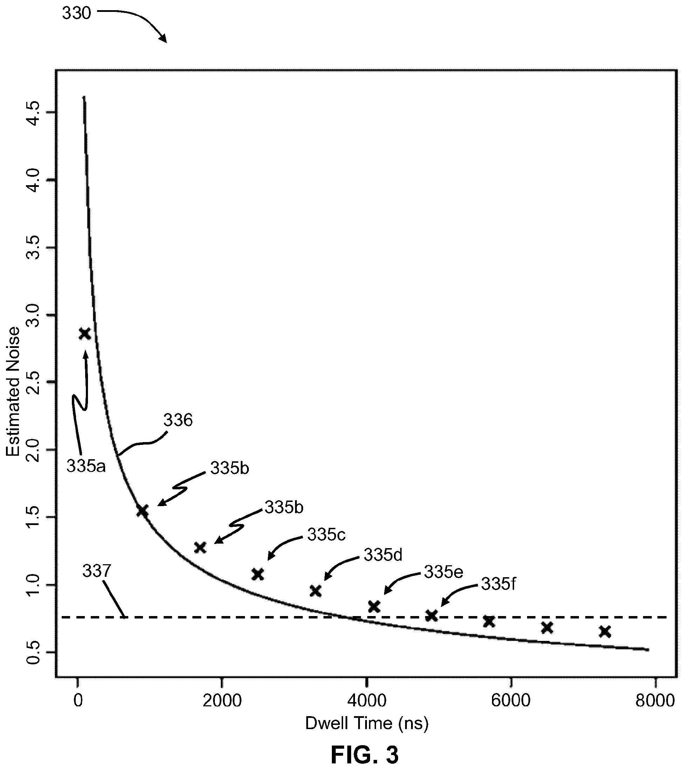

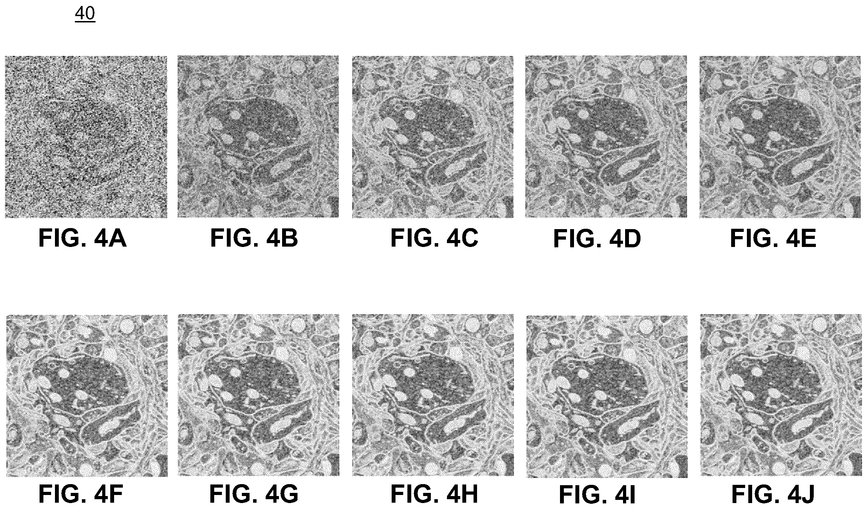

FIG. 3 shows an example of development of a mathematical relationship between operational settings and observed data as graph **330.** In this graph, the plotted points **335a, 335b, 335c, 335d, 335e, 335f,** ... (denoted by "x" symbols) represent estimated image noise, as plotted against pixel dwell time, in milliseconds. The plotted data points shown in FIG. 3 pertain to the images that are shown in FIGS. 4A-4J. Curve **336** represents a best fit to the data of a function of the form *y*(*x*) = *kx*^{-1/2}, where *x* represents dwell time, *y* represents the noise level (in arbitrary units) and *k* is a constant. An analyst may utilize the data of FIG. 3 to advantage if, as is commonly the case in tomographic studies, many thousands of slices through an object are to be imaged in order to perform a three-dimensional reconstruction of the object. For example, if the analyst considers that a noise level of 0.75, as shown by horizontal line **337** is acceptable (and if variation of other instrument parameters is not pertinent to the experiment), then the analyst may choose an appropriate dwell time of approximately 4000 ns, instead of a longer dwell time of 7500 ns. Depending upon the number of images that are required per sample and the number of samples that are to be analyzed, this dwell time adjustment may reduce the required analysis time by several minutes or even several hours.

For simplicity, FIG. 3 illustrates the variation of noise as a function of only a single adjustable parameter. One of ordinary skill in the art will recognize, however, that it may be necessary to properly adjust more than one operational parameter in order to successfully achieve, without sample damage, a below-threshold noise level (alternatively, an above-threshold signal-to-noise level) while using an acceptably short dwell time per analysis. Thus, for example, during investigations of the effects of parameter adjustments on noise levels (e.g., the method **350**), it may be necessary to consider the effects of changes of the various operational parameters in isolation from one another. For example, the iterated execution of the loop of steps **356-362** of the method **350** of FIG. 2 may include multiple groups of iterations in which only a single respective operational parameter is varied within each iteration group.

Returning to the discussion of method **350,** it may be seen that the mathematical best-fit model may, as finalized in step **368,** be either: (i) fully constructed in a single step after all data points **335a, 335b,** ... have been collected; (ii) expanded in real-time (i.e., during execution of the method **350**) by the inclusion of additional data; (iii) modified in form in real-time in response to additional data; (iv) reduced by the exclusion of some previously utilized data; (v) temporarily bypassed or (vi) finalized. According to some embodiments of the method **350,** the construction of the mathematical relationship between operational settings and imaging or analysis results may proceed in a traditional sense whereby all data points that are necessary for construction of the model are captured prior to using the model to create a best fit to the data in accordance with the model. According to this traditional procedure, the model that is created for each sample class may be stored for later use.

A problem with the above-mentioned traditional approach is that the model may need to be constantly calibrated for use with different analytical apparatuses or may need to be recalibrated for use with a single apparatus to account for either drift in the response of the apparatus or the appearance of background interference. Because of these issues, the inventors consider that a preferable procedure is to automatically update the mathematical model in real-time, while data is being collected. This procedure eliminates the need to separate the calibration of the model from the background interference such as may occur during long automated procedures in which hundreds or thousands of scans/acquisitions are being analyzed. In this way, deviation from an originally formulated prediction model may be recognized and accounted for by adjusting the model (e.g., updating the model in step **361**) during the analytical procedure. For example, the mathematical form of the model may be adjusted in real time by incorporating additional model parameters that account for instrument drift or background interference. This capability can allow an analyst or an artificial intelligence agent to automatically evaluate the acquisitions acquired during an extended analytical procedure, monitor the trend of the given metrics and automatically adjust scanning parameters to maintain consistent quality.

Additionally, the mathematical best-fit model may be modified, in real-time, by either the inclusion of additional data or the exclusion of some previously used data and subsequent recalculation of the best-fit mathematical relationship using the somodified data set. For example, newly included data may include the results from a recent measurement of detected emissions from the sample. Accordingly, the best-fit relationship may be recalculated after each such measurement, generally improving the predictive accuracy of the model. With greater predictive accuracy, the trend line of the model (e.g., curve **336**) may be more accurately extrapolated to a settings value at which a desired result is achieved, such as a setting at which the noise level is at or below a desired threshold level (e.g., line **337** in FIG. 3). Alternatively, the predictive accuracy may, in some instances, be improved by exclusion of certain outlier data points that have a high degree of uncertainty. For example, because of the high level of uncertainty associated with calculating a numerical noise level value of a highly-noisy image (e.g., FIG. 4A), the resulting uncertainty of the data point **335a** (FIG. 3) pulls down the best-fit curve **336** relative to the locations of all of the remaining data points. Exclusion of the data point **335a** from the best fit calculation would create a more accurate fit to the remaining data points.

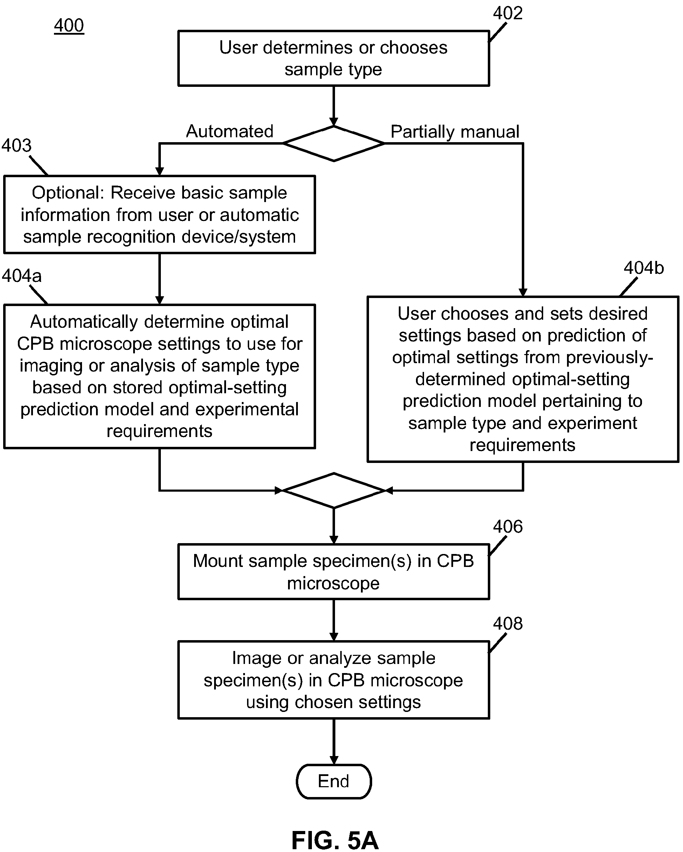

FIG. 5A is a flow diagram of a method **400** for utilizing a previously-determined prediction model of charged-particle-beam microscope quality metrics (e.g., total time required, noise and/or signal level, level of sample damage) as a function of various scanning parameter settings (e.g., sample class, pixel dwell time, choice of line integration imaging mode versus frame integration imaging mode, etc.) that affect one or more of: total analysis time, image quality and presence or absence of sample damage. For example, the previously determined prediction model may be constructed by the execution of the method **300** or execution of a method that is similar to or derived from the method **300.**

In step **402** of the method **400,** a user (e.g., an analyst) determines or chooses a sample of interest. The method **400** is suitable for any sample that may be analyzed in an electron microscope or in any charged-particle-beam microscope, regardless of whether or not the sample has been identified or otherwise characterized (e.g., in terms of composition, provenance, physical properties, etc.). Thus, in step **402,** a user may simply choose a sample for analysis even if an identification has not been made. Indeed, the results of a subsequent charged-particle-beam analysis (e.g., in step **408)** may serve to at least partially identify or characterize the sample. After execution of the step **402** of the method **400,** subsequent execution may follow one of two alternative paths, depending on whether the setting of instrument operational parameters is fully automated or, otherwise, is at least partially manual. In the automated execution procedure, the steps **403** and **404a** are executed. In step **403,** basic sample information (i.e., sample class - if available - plus any other pertinent experimental requirement, such as information relating to acceptable thresholds, maximum time for analysis, etc.) is either: (a) received (e.g., by data-processing system **250)** from an analyst or other user, or (b) automatically recognized by one or more sensors (e.g., spectroscopic sensors), possibly in conjunction with an artificial intelligence classifier. Then, in the following step **404a,** an optimum set of parameters are automatically predicted (e.g., by parameter settings component **242** of the data-processing system **250)** based on the available received sample information and the stored prediction model. Alternatively, in the partially manual procedure, the analyst or user chooses and sets desired instrument settings, in step **404b,** based on known usable settings that are retrieved from a previously-determined prediction model, as they pertain to the chosen sample class, if known, and further based on the desired experiment requirements. Specimen(s) of the chosen sample may then be mounted on a sample stage (or other sample support structure) of the charged particle beam microscope in step **406.** Of course, it is only necessary for this specimen mounting step **406** to be performed prior to execution of the imaging/analysis step **408.** Accordingly, the mounting step **406** may be performed prior to any of the steps that are shown as preceding it in FIG. 5A. The mounted specimen(s) are imaged or analyzed in the CPB microscope using the chosen or the automatically predicted instrument operational parameters.

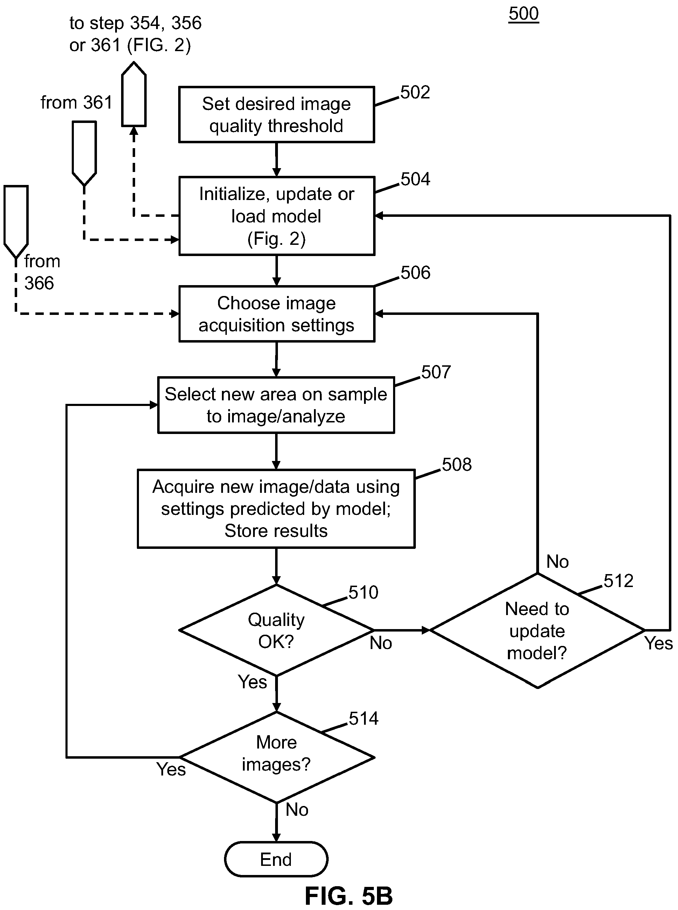

FIG. 5B is a flow diagram of a method, method **500,** in accordance with the present teachings, that either utilizes an existing prediction model of CPB microscope settings or, alternatively, causes a model to be either generated or updated. An advantage of the method **500** is that it makes use of the sample that is to be analyzed and the same CPB microscope. Thus, the method **500** makes no assumptions with regard to either the type of sample that is under analysis or the existence of a suitable predictive model. Neither the identity nor the characteristics of the sample are required as input to the model. Because of the potential dual usage cases of the method **500,** it may be necessary for the method to reproduce or access steps of the method **350** that is diagrammed in FIG. 2. For example, in a computer implementation, the method **350** may comprise a computer program sub-routine that has different entry points that may be called by another program and that has different exit points at which it may return the results of calculations to the calling program. The potential flow of control between the two routines is indicated by dashed arrows in both FIG. 2 and FIG. 5B.

In a first step, step **502,** of the method **500,** a desired image quality metric is set. In the second step, step **504,** an operational-settings prediction model is either initialized, updated or retrieved. According to the flow of control that is illustrated in FIG. 5B, the method may call the step **361** of the method **350** to perform any of these tasks and may receive results back from step **361.** Thus, when step **504** is executed for the first time after the execution of step **502,** the step **504** may call step **361** to provide the model definition and parameters and may, additionally, call step **361** to initialize the model, if not previously initialized. Alternatively, when no suitable model exists, execution may pass from step **504** of method **500** to step **356** of the method **350,** without change of sample, whereby a new predictive model is generated, according to all of the steps **356** through **366.** The parameters and form of the new predictive model may be returned to the method **500** at its step **506.** In this way, a CPB settings predictive model for the specific sample at hand may be generated, even in the absence of prior knowledge about the sample. The various steps of the method **500** are discussed in detail below.

In step **506** of the method **500,** image acquisition operational settings are chosen. When step **506** is executed for the first time after the execution of step **502,** these settings are "initial" trial settings; when step **506** is executed for second and subsequent times, the settings are generally "updated" settings. After the settings (either initial or updated) have been chosen, execution of the method **500** may comprise, in a first scenario, one or more repetitions of the loop of steps comprising step **507,** step **508,** step **510** and step **514.** In a second scenario, the execution may comprise one or more repetitions of the loop of steps comprising steps **507, 508, 510, 512** and **506.** The results of step **510** determine which of these scenarios is executed.

Steps **507, 508** and **510** in either of the first and second scenarios mentioned above. In step **507,** a new location on the sample is selected for imaging and/or analysis. In step **508,** the selected area is imaged and/or otherwise analyzed using the most recently chosen operational settings and most recently set model parameters and the analytical results are stored. In step **510,** the analysis results are examined to: (a) assess if the quality of the most recently acquired image or data is greater than or equal to the quality metric threshold that was set in step **502;** (b) whether or not the existing model accurately predicts recently-observed data; and (c) if the sample has incurred damage from CPB exposure. In the first scenario noted above, the image quality is above the threshold, observed results are within confidence intervals of the predictive model, and the sample has not incurred damage, all of which may be determined in step **510.** In this scenario, if there are additional locations on the sample that are to be imaged and/or analyzed (step **514),** execution of the method returns to step **507** and the steps **507-514** are repeated using the same operational parameters. Otherwise, if, in step **514,** it is determined that no other areas on the sample are to be analyzed or imaged, execution of the method **500** may terminate. Thus, this first scenario corresponds to choosing, based on existing model parameters, appropriate operational settings in step **506** and using the appropriately chosen settings to image the sample.

The second scenario that is described above corresponds to situations in which it is determined, in step **510,** that the data quality is insufficient or the sample area has been damaged during analysis; and in which it is also determined, in step **512,** that (b) an update to the prediction model is not indicated by the existing data. In this scenario, it is necessary to change the operational settings used by data acquisition. Thus, the flow of control passes from step **512** to step **506** at which the operational settings are changed. Subsequent repetitions of the steps **507, 508, 510** and **512** while using repeatedly changed settings may continue until the quality of the data exceeds the quality threshold (as set in step **502**) while the sample remains undamaged.

A third scenario exists in which, after the acquisition of some data (e.g. image data), it is determined that the existing model does not adequately represent presently obtained data, as determined from the assessment in step **510,** and thus should be updated. In this scenario, the "Yes" branch of step **512** is followed, which returns control to step **504,** which then provides the recently obtained data to step **361** of the method **350.** Step **361** then updates the mathematical model to more closely fit the recently obtained data and returns the updated model back to step **504,** as schematically depicted in both FIG. 2 and FIG. 5B. As but one example, a prior model having a total of *n* adjustable parameters (where *n* is an integer) may be superseded by an updated model having *n*+1 adjustable parameters. Afterwards, execution of the method 500 passes to and resumes at step **506.**

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While specific illustrated example embodiments described herein specifically depict Scanning Electron Microscope (SEM) systems, these are meant as non-limiting, illustrative embodiments. Embodiments of the present disclosure are not limited to such systems, but rather are intended to include Focused Ion Beam (FIB) systems as well as Transmission Electron Microscope (TEM) systems and Scanning Transmission Electron Microscope (STEM) systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the claims.

## Claims

1. A method for constructing a Charged Particle Beam (CPB) microscope operational-settings prediction model, comprising:
setting one or more microscope operational parameters to respective initial values;
directing a charged particle beam onto a location of a specimen of a known sample class and imaging or analyzing the location using the most recently set microscope operational parameters while detecting emissions from the specimen;
repeatedly:
changing a value of at least one of the one or more operational parameters;
directing the charged particle beam onto the specimen location and imaging or analyzing the specimen location using the most recently set microscope operational parameters while detecting emissions from the specimen location; and
recording the values of the microscope operational parameters and recording a value that is a measure of the detected emissions from the specimen location; and
constructing and storing a mathematical relationship, corresponding to a best-fit model, that pertains to the known sample class, between at least one variable that represents a microscope operational parameter and a variable that represents the detected emissions.

2. A method as recited in claim 1, wherein the charged particle beam is an electron beam within an electron microscope.

3. A method as recited in claim 1, wherein the charged particle beam is an ion beam within a Focused Ion Beam apparatus.

4. A method as recited in any of claims 1-3, further comprising modifying the best-fit model in real-time during the detecting of emissions from the location.

5. A method as recited in claim 4, wherein the modifying of the best-fit model comprises modifying a mathematical form of the model in response to recently detected emissions from the location.

6. A method as recited in any one of the preceding claims, further comprising recalculating the mathematical relationship that corresponds to the best-fit model in real-time in response to recently detected emissions from the location.

7. A method as recited in claim 6, wherein the recalculating of the mathematical relationship that corresponds to the best-fit model comprises excluding one or more data points from the recalculation.

8. A method as recited in claim 6, wherein the modifying of the best-fit model comprises recalibrating the best-fit model to account for effects, on the detected emissions, of instrumental drift or background interference.
